# Europäisches Patentamt

## European Patent Office

## Office européen des brevets

(11) Veröffentlichungsnummer: **0 088 400**
A2

(12) ## EUROPÄISCHE PATENTANMELDUNG

(21) Anmeldenummer: 83102145.6

(51) Int. Cl.³: **H 03 H 9/145**

(22) Anmeldetag: 04.03.83

(30) Priorität: 08.03.82 DE 3208252

(43) Veröffentlichungstag der Anmeldung: 14.09.83
Patentblatt 83/37

(84) Benannte Vertragsstaaten: **BE DE FR GB NL**

(71) Anmelder: **SIEMENS AKTIENGESELLSCHAFT, Berlin und München Wittelsbacherplatz 2, D-8000 München 2 (DE)**

(72) Erfinder: **Ehrmann-Falkenau, Ekkehard Dipl.-Ing., Dr., Alfred-Neumann-Anger 14, D-8000 München 85 (DE)**
Erfinder: **Langecker, Karl, Ing.grad., Grünwalder Strasse 69, D-8000 München 90 (DE)**

(54) **Interdigitalwandler mit Unterdrückung reflektierter Störsignale.**

(57) An dem einen (Empfangs-)Wandler (4) entgegengesetzten Ende des anderen (Sende-)Wandlers (3) treten Reflexionen der erzeugten (bzw. empfangenen) Oberflächenwelle auf, die dem Nutzsignal starke Störsignale überlagern können. Mit den erfindungsgemäss an diesem (jeweiligen) Ende hinzugefügten ein oder mehreren Zusatzfingern (10′ mit 10″, 11′ mit 11″ ...; 40, 41) lässt sich bei erfindungsgemässer Abstandsbemessung $\lambda_O/4$ ein solches Reflexions-Störsignal verhindern.

EP 0 088 400 A2

SIEMENS AKTIENGESELLSCHAFT
Berlin und München

0088400

Unser Zeichen
VPA 82 P 1 1 6 3 E

## Interdigitalwandler mit Unterdrückung reflektierter Störsignale.

Die vorliegende Erfindung bezieht sich auf einen Interdigitalwandler, wie er im Oberbegriff des Patentanspruchs 1 angegeben ist.

Aus 'Surface Wave Filters' von H. Methews, Verlag Wiley New York, 1977 sind Interdigitalwandler bekannt, die auf einem Substrat aus z.B. Lithiumniobat aufgebrachte, in Längsrichtung des Wandlers nebeneinander angeordnete Elektrodenfinger aufweisen. Einzeln oder in 'split-finger'-Anordnungen (paarweise) sind diese Elektrodenfinger abwechselnd mit einem der 'bus bars' elektrisch verbunden.

Eine weitere Anordnung ist aus 'Transactions JECE of Japan', Bd.64-C (1981), Seiten 437-438 bekannt, bei der das dem Empfangswandler zugewandte Ende des Sendewandlers einen zusätzlichen Finger im Abstand $\lambda_0/2$ besitzt, der die ansonsten auftretende Erzeugung eines Störsignals des letzten Wandlerfingers vermindert.

Als Sendewandler wird bei Anliegen eines elektrischen Hochfrequenzfeldes zwischen den 'bus bars' im Bereich der Elektrodenfinger in der Oberfläche des piezoelektrischen Substrats eine akustische Oberflächenwelle (SAW) erzeugt, wobei $\lambda_0$ die Wellenlänge der Oberflächenwelle ist, die durch den Abstand der Elektrodenfinger voneinander gegeben ist. Bei Einzelfingeranordnung ist deren Abstand $\lambda_0/2$. Bei einer 'split-finger'-Anordnung haben deren einzelne Elektrodenfinger Abstände $\lambda_0/4$ voneinander, d.h. der Mittenabstand zweier jeweils benachbarter, an verschiedenen 'bus bars' angeschlossener Fingerpaare beträgt wiederum $\lambda_0/2$.

Bts 1 Bla / 8.3.1982

0088400
82 P 1 1 6 3 E

Solche Wandler können auch als Empfangswandler verwendet werden. In einem solchen Wandler wird eine akustische Welle in ein zwischen den 'bus bars' abzunehmendes elektrisches Hochfrequenzsignal umgewandelt, dessen Mittenfrequenz (ebenfalls) durch den Wert der Wellenlänge $\lambda_o$ bzw. die Mittenabstände $\lambda_o/2$ benachbarter Elektrodenfinger bzw. Elektrodenfingerpaare bestimmt ist.

Von besonderer Bedeutung sind Wandler mit sogenannten gewichteten Elektrodenfingern. Bei einer solchen Anordnung ist ein wie voranstehend beschriebener Elektrodenfinger in seiner Länge quer zur Längsrichtung des Wandlers und das abgeteilte Fingerteil ist im Regelfall elektrisch mit dem gegenüberliegenden anderen 'bus bar' verbunden. Bis auf das kurze Stück Unterbrechung erstreckt sich somit eine solche in zwei Teile aufgeteilte Fingerelektrode vom einen 'bus bar' bis zum gegenüberliegenden 'bus bar'. Ein solches Fingergebilde wird im nachfolgenden insgesamt als Fingerkollektiv bezeichnet. Es sei hier vorweg darauf hingewiesen, daß ein solches Fingerkollektiv nicht nur aus zwei, sondern auch aus noch mehreren Fingeranteilen bestehen kann, wobei sich somit diese zwei oder mehreren Fingeranteile zusammen mit ihren Unterbrechungen in einer Linie vom einen bis zum anderen gegenüberliegenden 'bus bar' erstrecken. Diese Linie ist meistenteils eine Gerade. In Sonderfällen (Patentanmeldung 28 39 851 = VPA 78P7117) kann sie auch aus mehreren aneinanderhängenden geradlinigen Teilstücken bestehen. Im Sinne der Erfindung gehört zum Begriff eines Fingerkollektivs aber auch ein nur einteiliger Elektrodenfinger, der sich vom einen 'bus bar' bis nahe zum gegenüberliegenden 'bus bar' erstreckt und der keinen gegenüberliegenden, z.B. mit diesem anderen 'bus bar' verbundenen, Fingeranteil hat.

0088400
82 P 1163 E

Diese bekannten Interdigitalwandler haben in Längsrichtung zwangsläufig eine bestimmte Länge und an einem jeden ihrer Enden bildet ein Fingerkollektiv zwangsläufig das letzte Fingerkollektiv, das für gewollte Wellenerzeugung oder für gewollten Wellenempfang wirksam ist. Die Gesamtheit der Elektrodenfinger (oder Fingerkollektive im Sinne der Erfindung) ist für sich genommen ein Wandler, innerhalb dessen ein wesentlicher Anteil (im Regelfall etwa die Hälfte) der Substratoberfläche mit dem Metall der Elektrodenfinger bedeckt ist. In Richtung der Wellenausbreitung der akustischen Welle (SAW) folgt jenseits des (jeweils) letzten Elektrodenfingers bzw. Fingerkollektivs im Regelfall nur noch Oberfläche des Substrats, das frei von solchen Fingerkollektiven ist. Das letzte Fingerkollektiv bildet somit für den Wandler eine gewisse Stoßstelle, an der eine Reflexion für diejenige akustische Welle auftritt, die innerhalb des Wandlers erzeugt worden (oder im Falle als Empfangswandler in den Wandler von außen hineingelangt) ist und auf das betreffende Ende des Wandlers hin zuläuft. Es läuft zwar der wesentliche Anteil dieser auf das betreffende Ende des Wandlers zulaufenden Welle weiter in den sich anschließenden Außenraum. Ein jedoch nicht zu vernachlässigender Anteil dieser Welle wird am letzten Fingerkollektiv zurückreflektiert, nämlich zurück in den Wandler. Bei dieser Reflexion spielt vor allem die - bezogen auf den Wandler - äußere Kante des letzten Fingerkollektivs eine Rolle. Dieser reflektierte Anteil der Welle läuft im Wandler wieder zurück in Richtung auf das gegenüberliegende Ende desselben. Dieser Anteil tritt dort aus dem Wandler aus, als wäre dieser Anteil (bei einem Sendewandler) primär im Wandler erzeugt bzw. erzeugt (bei einem Empfangswandler) in diesem erneut ein (Stör-)Signal. Dieser erst aufgrund einer Reflexion auftretende Anteil hat im Regelfall eine

Phasenverschiebung gegenüber dem Nutzsignal.

Es ist eine Aufgabe der vorliegenden Erfindung, eine möglichst einfach zu realisierende und keine andere, neue Störquelle hervorrufende Maßnahme für einen Interdigitalwandler anzugeben, mit der dieser Wandler wenigstens weitestgehend (genau genommen bei der Mittenfrequenz) frei von einem wie oben beschriebenen, auf Reflexion beruhenden Störsignal gemacht ist.

Diese Aufgabe wird mit einem Interdigitalwandler nach dem Oberbegriff des Patentanspruchs 1 erfindungsgemäß mit den Merkmalen des Kennzeichens des Anspruchs 1 gelöst.

Der vorliegenden Erfindung liegt die Idee zugrunde, durch Anordnung eines oder mehrerer zusätzlicher Fingerkollektive am betreffenden Ende des Wandler ein Reflexionssignal zu eliminieren. Diese zusätzlichen Fingerkollektive müssen dabei nicht mit dem einen oder dem anderen 'bus bar' verbunden sein. Eine solche elektrische Verbindung (wie sie die Fingerkollektive des Wandlers notwendigerweise haben) kann jedoch von (weiterem) Vorteil sein. Es ist eine Anzahl N Zusatzfingerkollektive vorgesehen, wobei N größer oder gleich 1 ist, die in Fortsetzung der Längsrichtung des Wandlers nebeneinander auf das letzte Fingerkollektiv des Wandlers folgend angeordnet sind. Die erfindungsgemäße Besonderheit ist,
1) daß die (bezogen auf den Wandler) äußere Fingerkante des auf das letzte Fingerkollektiv des Wandlers folgenden Zusatzfingerkollektivs von dessen äußerer Fingerkante und die äußere Fingerkante jedes weiteren Zusatzfingerkollektivs von derjenigen des benachbarten Zusatzfingerkollektivs einen Abstand von (jeweils $\lambda_o/4$ hat, und

2) daß außerdem - bezogen auf die Gesamtfingerlänge L des letzten Fingerkollektivs des Wandlers - das folgende Zusatzfingerkollektiv eine von diesem unterschiedliche kürzere Gesamtfingerlänge besitzt, und weitere Zusatzfingerkollektive (soweit vorhanden) eine monoton abgestuft jeweils noch kürzere Gesamtfingerlänge haben.

Es gelten somit für den jeweiligen Abstand der äußeren Fingerkante eines Zusatzfingerkollektivs von der äußeren Fingerkante des letzten Fingerkollektivs des Wandlers die Werte $n \cdot \lambda_0/4$, worin n für das n-te Zusatzfingerkollektiv steht und die jeweilige Gesamtfingerlänge beträgt $(1-\frac{n}{N+1})L$. Die erfindungsgemäße Abstimmung von Abstand und jeweiliger Gesamtlänge der erfindungsgemäß vorgesehenen zusätzlichen Fingerkollektive sind miteinander derart zusammenwirkend, daß die gestellte Aufgabe gelöst wird.

Mit Hilfe der Weiterbildung gemäß den Maßnahmen des Patentanspruchs 2 läßt sich darüber hinaus zusätzlich noch erreichen, daß gleichzeitig auch solche Störsignale wenigstens weitgehend ausgeschlossen werden, die auf Wellenerzeugung am jeweils letzten Fingerkollektiv des Wandlers beruhen. Dabei wirken zur Lösung dieses der Weiterbildung zugrunde liegenden Problems jeweils zwei Fingerkollektive funktionell zusammen, und zwar vom letzten Fingerkollektiv des Wandlers aus gesehen dieses mit dem zweiten zusätzlichen Fingerkollektiv, das erste zusätzliche Fingerkollektiv mit dem dritten zusätzlichen Fingerkollektiv, usw.

Weitere Erläuterungen der Erfindung gehen aus der nachfolgenden, anhand der Figur gegebenen jeweiligen Beschreibung bevorzugter Ausführungsbeispiele und/oder vorteilhafter Weiterbildungen der Erfindung hervor.

Die Figur zeigt in Aufsicht eine Oberflächenwellenanordnung, z.B. ein Oberflächenwellenfilter, mit zwei Interdigitalwandlern.

Die Darstellung der Figur dient insoweit in erster Linie zur Erläuterung, als die dort dargestellte Oberflächenwellenanordnung mehrere verschiedene Ausführungsformen der Erfindung enthält. Diese verschiedenen Ausführungsformen können bei einem praktisch zu verwendenden Oberflächenwellenfilter zwar in der dargestellten Weise vorhanden sein, jedoch wird man häufig für eine Fingeranordnung durchweg die eine, die andere oder eine dritte Ausführungsform der Erfindung oder z.B. nur zwei derselben zusammen in einer Anordnung verwenden.

Mit 2 ist ein plattenförmiges Substrat bezeichnet, das z.B. aus Lithiumniobat besteht. Auf der in der Darstellung der Figur sichtbaren Oberfläche dieses Substrats 2 sind zwei Wandleranordnungen 3, 4 dargestellt, von denen z.B. der Wandler 3 als Sendewandler und der Wandler 4 als Empfangswandler verwendet werden kann. In üblicher Weise bestehen diese Wandler 3, 4 aus einer auf der Oberfläche aufgebrachten Metallisierungsstruktur, die vorzugsweise auf fotolithografischem Wege erzeugt wird.

Der Wandler 3 ist in 'split-finger'-Anordnung ausgeführt, was schon daran zu erkennen ist, daß jeweils paarweise zwei benachbarte Elektrodenfinger 5 mit dem jeweils selben 'bus bar' verbunden sind, gleiche Länge haben(also ein Fingerpaar bilden) und daß für diese Finger des Wandlers 3 die Mittenabstände derselben $_o/4$ betragen. Der in der Figur linksseitig letzte Finger (zum besseren Erkennen durch Schwärzung darstellungsmäßig etwas hervorgehoben) besteht wie andere Elektrodenfinger des Wandlers 3 aus den beiden Anteilen 5' und 5", die sich einander in einer (hier geraden) Linie quer zur Längsrichtung des Wandlers und mit einem kleinen Abstand gegenüberstehen. Diese Elektrodenfingeranteile 5' und 5" bilden zusammengenommen (im Sinne der Erfindung definiert) ein Fingerkollektiv, das im weiteren mit 5 bezeichnet wird. Mit 6 ist die im Patentanspruch angegebene - bezogen auf den betreffenden Wandler.- äußere Kante eines jeglichen Elektrodenfingers bezeichnet, die für die erfindungsgemäße Bemessung der Abstände wichtig ist.

Mit 15' und 15" sind die Elektrodenfingeranteile des im folgenden insgesamt mit 15 bezeichneten letzten Fingerkollektivs des rechtsseitigen Endes des Wandlers 3 bezeichnet.

Mit 7 und 7' sind die 'bus bars' bezeichnet.

Der zur Erzeugung einer Oberflächenwelle zu verwendende Wandler 3 wird somit durch die beiden letzten Fingerkollektive 5 und 15 begrenzt. Innerhalb dieses Bereichs des Substrats 2 werden durch Anlegen einer elektrischen Hochfrequenzspannung an die 'bus bars' 7, 7' Oberflächenwellen erzeugt oder Oberflächenwellen in an den 'bus bars' anliegendes elektrisches Signal umgeformt.

An dem bereits erwähnten linksseitigen Ende des Wandlers 3 sind entsprechend einer Ausführungsform der Erfindung drei Zusatzfingerkollektive (jeweils mit 10, 11, 12 bezeichnet) dargestellt, die aus jeweils den Elektrodenfingern 10', 10" bzw. 11', 11" bzw. 12', 12" bestehen. Wie auch aus der Figur ersichtlich, beträgt der Abstand der äußeren Fingerkante 6 der Elektrodenfinger 10', 10" des Fingerkollektivs 10 von der äußeren Kante 6 der Elektrodenfinger 5' und 5" des Fingerkollektivs 5, das das letzte Fingerkollektiv des Wandlers 3 ist, erfindungsgemäß $\lambda_o/4$, worin $\lambda_o$ die der Mittenfrequenz des Wandlers 3 entsprechende Wellenlänge der Oberflächenwelle in der Oberfläche des Substrats 2 ist. Die äußeren Kanten 6 der Elektrodenfinger 11', 11" des nächstfolgenden Zusatzfingerkollektivs 11 haben von der äußeren Kante 6 des letzten Fingerkollektivs 5 des Wandlers 3 einen Abstand von $2 \cdot \lambda_o/4$. Für das dritte Zusatzfingerkollektiv 12 dieser speziellen Ausführungsform der Erfindung beträgt der entsprechende Abstand $3 \cdot \lambda_o/4$. Im Patentanspruch ist der laufende Index n für erfindungsgemäß vorgesehene Zusatzfingerkollektive verwendet und für das Zusatzfingerkollektiv 10 ist n = 1, für das Zusatzfingerkollektiv 11 ist n = 2 und für das Zusatzfingerkollektiv 12 ist n = 3.

Weiter gehört zur Erfindung, daß die Gesamtlänge für die einzelnen Zusatzfingerkollektive bestimmte Längen in bezug auf die Gesamtlänge des letzten Fingerkollektivs 5 des Wandlers 3 haben. Mit dem Doppelpfeil L ist die Gesamtlänge des letzten Fingerkollektivs 5 des Wandlers 3 bezeichnet, die praktisch gleich dem Abstand der 'bus bars' 7 und 7' voneinander an dieser Stelle ist. Mit L1 und L2 (für $L_i$) sind die Einzellängen der Elektrodenfinger 5' und 5" des letzten Fingerkollektivs 5 angegeben. Es gilt im wesentlichen L = L1+L2, d.h. der Abstand zwischen den einander gegenüberstehenden Fingern 5' und 5" ist im Verhältnis zur Gesamtlänge L vernachlässigbar.

Erfindungsgemäß müssen hier vorgesehene Zusatzfingerkollektive eine jeweils abgestuft verkürzte Länge haben. Das Fingerkollektiv 10 hat bei hier insgesamt N = 3 Zusatzfingerkollektiven eine Gesamtlänge von $3/4 \cdot L$. Das Zusatzfingerkollektiv 11 (n = 2) hat dementsprechend eine Gesamtlänge von $2/4 \cdot L$ und das äußerste Fingerkol-

lektiv (n = 3) hat eine Gesamtlänge von $\frac{L}{4}$ . Die jeweils /restliche Länge ist (bei dieser Ausführungsform) vorhandener Abstand zwischen den jeweils beiden einander gegenüberstehenden Enden der Finger 10', 10" bzw. 11', 11" bzw. 12', 12" der einzelnen Fingerkollektive 10 bzw. 11 bzw. 12.

Mit einer solchen Anzahl N Zusatzfingerkollektive und mit solchen Abmessungen wird bereits die Aufgabe gelöst, auf Reflexion der im Wandler 3 erzeugten Oberflächenwelle an der äußeren Fingerkante 6 des Fingerkollektivs 5 beruhendes Störsignal (bei Mittenfrequenz) im wesentlichen vollständig zu beseitigen. Die Zusatzfingerkollektive 10, 11, 12 bewirken dies aufgrund von Interferenzen.

Wenn der Wandler 3 als Sendewandler und der Wandler 4 als Empfangswandler dienen, ist die erfindungsgemäße Anordnung eines oder mehrerer Zusatzfingerkollektive an dem wie beschrieben linksseitigen Ende des Wandlers 3 deshalb von großer Bedeutung, weil ein Reflexions-Störsignal an diesem linken Ende wieder nach rechts in den Wandler 3 zurückläuft und weiter nach rechts in den Empfangswandler 4 gelangt. Dort im Wandler 4 ist es phasenverschoben gegenüber dem Nutzsignal des Wandlers 3.

Es kann aber auch zweckmäßig sein, auf dem rechtsseitigen Ende des Wandlers 3 eine der erfindungsgemäßen Ausführungsformen mit Zusatzfingerkollektiv(en) vorzusehen. Die Figur zeigt auch ein solches Beispiel, wobei jedoch das (als Beispiel nur eine) Zusatzfingerkollektiv 20, bestehend aus den Fingern 20' und 20", nur gestrichelt dargestellt ist. Auch hier hat wieder der Abstand zwischen der äußeren Fingerkante 6 des letzten Fingerkollektivs 15 und der äußeren Fingerkante 6 des Fingerkollektivs 20 den Wert $\lambda_o/4$. (Es können auch noch weitere Zusatzfingerkollektive - wie das Fingerkollektiv 20 - weiter nach rechts folgend angeordnet sein.) Auch an diesem rechtsseitigen Ende des Wandlers 3 ist die Gesamtlänge des Zusatzfingerkollektivs 20 erfindungsgemäß bemessen, nämlich die Gesamtlänge der Elektrodenfinger 20' und 20" beträgt $\frac{L}{2}$ (entsprechend einer Gesamtlänge L des letzten Fingerkollektivs 15 des Wandlers 3 und für N = 1).

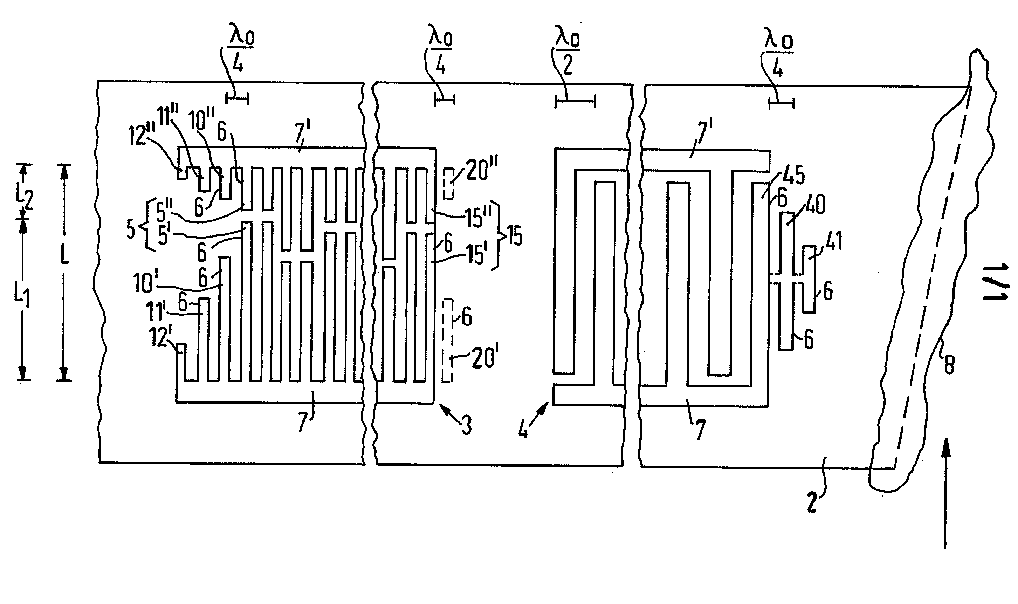

In der schon vorangehend zum linksseitigen Ende des Wandlers 3 beschriebenen Ausführungsform der Erfindung ist außerdem - wie schon angedeutet - auch noch eine Weiterbildung (gemäß Anspruch 2) enthalten. Mit dieser können außerdem auch Störsignale beseitigt werden, die darauf beruhen, daß von der äußeren Kante 6 des letzten Fingerkollektivs 5 des Wandlers 3 ausgehend Störsignale erzeugt werden, die dann vom Wandler 3 weg nach (in der Fig.1) links in einen dort vorhandenen (nicht dargestellten) weiteren Empfangswandler gelangen können. Diese Weiterbildung der Erfindung besteht außerdem noch darin, daß die obige erfindungsgemäße Längenabstufung nicht nur auf das Maß der Gesamtlänge der einzelnen Fingerkollektive 10, 11, 12 angewendet ist, sondern daß diese Längenabstufung auch bei den einzelnen Elektrodenfingern 10', 11', 12' und 10", 11" und 12" untereinander vorliegt. Dabei richtet sich diese gemäß der Weiterbildung der Erfindung vorgesehene Längenabstufung der Elektrodenfinger 10', 11', 12' bzw. 10", 11", 12" nach dem jeweils zugeordneten letzten Elektrodenfinger 5' bzw. 5". Letztere haben die jeweilige Länge L1 bzw. L2. Zum noch besseren Verständnis sei hilfsweise darauf hingewiesen, daß die Figur hierzu eine möglichst genaue Wiedergabe ist.

Die zusätzliche Wirkung dieser Weiterbildung der Erfindung ist erreicht, weil die Fingerkollektive paarweise

0088400

zusammenwirken. Es wirkt der Elektrodenfinger 5' gemeinsam mit dem Elektrodenfinger 11', der Elektrodenfinger 5" gemeinsam mit dem Elektrodenfinger 11", der Elektrodenfinger 10' gemeinsam mit dem Elektrodenfinger 12' und der Elektrodenfinger 10" mit dem Elektrodenfinger 12", die jeweils untereinander Abstände von $2 \cdot \lambda_o/4$ haben und zueinander abgestuft lang sind. Um diese zusätzliche Wirkung mit der erfindungsgemäßen Ausführungsform zu erreichen, ist außerdem notwendig, daß die Fingerelektroden der Zusatzfingerkollektive 10, 11, 12 elektrisch mit dem jeweiligen 'bus bar' 7 bzw. 7' verbunden sind, mit dem auch der zugeordnete letzte Elektrodenfinger 5' bzw. 5" des Wandlers 3 verbunden ist.

Die Figur zeigt auch für den Wandler 4 eine (wieder andere) erfindungsgemäße Ausführungsform. Der Wandler 4 hat keine 'split-finger'-Anordnung. Die Mittenabstände der einzelnen Finger betragen beim Wandler 4 wie üblich $\lambda_o/2$. Mit 45 ist der (rechtsseitig) letzte Elektrodenfinger des Wandlers 4 bezeichnet. Ihm folgen noch zwei Zusatzelektrodenfinger 40, 41. Von der äußeren Kante 6 des Elektrodenfingers 45 hat die äußere Kante 6 des ersten Zusatzelektrodenfingers wieder einen Abstand von $\lambda_o/4$. Der entsprechende Abstand bis zur äußeren Fingerkante 6 des zweiten Zusatzelektrodenfingers 41 beträgt $2 \cdot \lambda_o/4$. Da hier N = 2 Zusatzelektrodenfinger vorgesehen sind, hat die erfindungsgemäß abgestufte Länge des ersten (n=1) Zusatzelektrodenfingers 40 den Wert $\frac{2}{3} L$ und die des zweiten Zusatzelektrodenfingers 41 den Wert $\frac{L}{3}$ (wobei L wieder die unter Vernachlässigung des Fingerspalts geltende Gesamtlänge des für den Wandler 4 letzten Elektrodenfingers 45 ist). Zur Unterdrückung der Reflexion ist es an sich nicht notwendig, daß die Zusatzelektrodenfinger 40, 41 ... elektrisch mit dem einen oder dem anderen 'bus bar' 7, 7' oder mit dem letzten Elektrodenfinger 45 elektrisch verbunden sind. Es kann aber aus weiteren Gründen eine solche Verbindung vorgesehen sein, wie sie als Beispiel gestrichelt in der Figur dargestellt ist. Die Zusatzelektrodenfinger 40, 41 ... sind beispielsweise jeweils mittig - wie dargestellt - mit dem letzten Elektrodenfinger 45 des Wandlers 4 verbunden.

Lediglich der Vollständigkeit halber sei der als Dämpfungsmittel dienende akustische Sumpf 8 am (rechtsseitigen) Ende des Substrats 2 erwähnt. Er verhindert eine Rückreflexion von Oberflächenwellen, die in seinen Bereich gelangen. Er ist aber nicht in der Lage, an der äußeren Fingerkante 6 des Wandlers 4 auftretende Zurückreflexion einer solchen Welle zu verhindern, die aus dem Wandler 4 (in der Figur) von rechts auf diese Fingerkante 6 des letzten Elektrodenfingers 45 trifft. Diese Reflexion unterdrückt erst die erfindungsgemäß vorgesehenen Zusatzfingerelektroden 40 und 41.

. <u>Patentansprüche:</u>

1. Interdigitalwandler mit auf einem Substrat in Längsrichtung des Wandlers nebeneinander angeordneten Fingerkollektiven aus quer zur Längsrichtung des Wandlers einander gegenüberstehenden Elektrodenfingern, die mit jeweils einem der 'bus bars' in vorgegebener Folge aufeinanderfolgend elektrisch verbunden sind, und wobei im Wandler für dessen Mittenfrequenz die Wellenlänge der akustischen Welle einen Wert $\lambda_o$ hat,
g e k e n n z e i c h n e t dadurch,
daß zur Beseitigung von Störsignalen, die aufgrund von im Wandler erzeugten und an dessen Ende reflektierten Wellen entstehen würden, an dem wenigstens einen Ende des Wandlers eine Anzahl $N \geqq 1$ Zusatzfingerkollektive (10, 11, 12; 20; 40, 41) angeordnet sind, wobei von der – bezogen auf den Wandler (3; 4) äußeren Fingerkante (6) des an dem betreffenden Ende des Wandlers letzten Fingerkollektivs (5; 15; 45) bis zur äußeren Fingerkante (6) des jeweiligen von diesem letzten Fingerkollektiv ab gezählt n-ten Zusatzfingerkollektivs (10, 11, ...41) ein Abstand $n \cdot \lambda_o/4$ vorliegt;
und wobei quer zur Richtung des Wandlers (3; 4) gemessen die Gesamtfingerlänge innerhalb eines jeden Zusatzfingerkollektivs (10, 11 ... 41) $(1-\frac{n}{N+1}) \cdot L$ beträgt, worin L die Gesamtlänge des letzten Fingerkollektivs (5; 15;,45) des Wandlers (3; 4) ist.

2. Interdigitalwandler nach Anspruch 1, g e k e n n z e i c h n e t dadurch, daß gilt $N = 4\bar{n}-1$, worin $\bar{n}$ eine ganze Zahl $\geqq 1$ ist und wobei jedem Elektrodenfinger (5', 5") des letzten Fingerkollektivs (5) des wenigstens einen Endes des Wandlers (3) je eine Gruppe von N Zusatz-Elektrodenfingern (10', 11', 12', 10", 11", 12") zugeordnet ist, die - bezogen auf den Wandler (3) - von der äußeren Fingerkante (6) dieses letzten Fingerkollektivs (5) des Wandlers (3) zur äußeren Fingerkante (6) des jeweiligen von diesem letzten Fingerkollektov (5) gezählt n-ten Zusatzelektrodenfingers (10', 11', 12', 10", 11", 12") ein Abstand $n \cdot \lambda_o/4$ vorliegt, wobei die Länge der einzelnen benachbarten Zusatzelektrodenfinger (10'...12") jeweils einen Wert $(1 - \frac{n}{N+1}) \cdot L_i$ hat, worin $L_i$ mit $i=1$ bzw. 2 die Länge des zugeordneten Elektrodenfingers (5' bzw. 5") des letzten Fingerkollektivs (5) ist, und dadurch, daß die Zusatzelektrodenfinger des jeweiligen Index $i=1$ bzw. 2 elektrisch mit ihrem zugeordneten Elektrodenfinger (5' bzw. 5") des letzten Fingerkollektivs (5) verbunden sind.

3. Interdigitalwandler nach Anspruch 2, g e k e n n - z e i c h n e t dadurch, daß N = 3 Zusatzfingerkollektive (10, 11, 12) an wenigstens dem einen Ende des Wandlers (3) vorgesehen sind.

4. Interdigitalwandler nach Anspruch 1, 2 oder 3, g e - k e n n z e i ch n e t dadurch, daß Zusatzfingerkollektive (10, 11, 12; 40, 41) an demjenigen Ende eines Wandlers (3; 4) vorgesehen sind, das bezogen auf einen funktionell zugehörigen zweiten Wandler (4; 3) entgegengesetzt ist.

5. Interdigitalwandler nach einem der Ansprüche 1 bis 4, g e k e n n z e i c h n e t dadurch, daß die Breite der Elektrodenfinger der Zusatzfingerkollektive gleich der Breite der Elektrodenfinger des an diesem Ende des Wandlers letzten Fingerkollektivs ist.

1/1